(19) Europäisches Patentamt
European Patent Office
Office européen des brevets

(11) **EP 3 152 587 B1**

(12) **EUROPÄISCHE PATENTSCHRIFT**

(45) Veröffentlichungstag und Bekanntmachung des Hinweises auf die Patenterteilung:
**08.04.2020  Patentblatt 2020/15**

(21) Anmeldenummer: **15744105.6**

(22) Anmeldetag: **02.06.2015**

(51) Int Cl.:
*G01S 7/292* (2006.01)    *G01S 13/93* (2020.01)
*G01S 13/34* (2006.01)    *H03M 7/30* (2006.01)

(86) Internationale Anmeldenummer:
**PCT/DE2015/200339**

(87) Internationale Veröffentlichungsnummer:
**WO 2015/185058 (10.12.2015 Gazette 2015/49)**

(54) **RADARSYSTEM MIT OPTIMIERTER SPEICHERUNG VON ZWISCHENDATEN**

RADAR SYSTEM WITH OPTIMIZED STORAGE OF TEMPORARY DATA

SYSTÈME RADAR À MÉMORISATION OPTIMISÉE DE DONNÉES INTERMÉDIAIRES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.06.2014   DE 102014210769**

(43) Veröffentlichungstag der Anmeldung:
**12.04.2017   Patentblatt 2017/15**

(73) Patentinhaber: **Conti Temic microelectronic GmbH**
**90411 Nürnberg (DE)**

(72) Erfinder: WINTERMANTEL, Markus
**88131 Lindau (DE)**

(56) Entgegenhaltungen:
WO-A1-2014/029260    WO-A2-2010/115418
DE-C1- 4 427 656    US-A- 4 751 929

EP 3 152 587 B1

**Beschreibung**

Die Erfindung bezieht sich auf ein Radarsystem zum Einsatz für Fahrerassistenzsysteme im Kraftfahrzeug. Das Radarsystem besitzt erfindungsgemäß eine optimierte Speicherung von Zwischendaten bei Verwendung ein periodischen linearen Frequenzmodulation und einer mehrdimensionalen diskreten Fouriertransformation.

**Stand der Technik**

Kraftfahrzeuge werden zunehmend mit Fahrerassistenzsystemen ausgerüstet, welche mit Hilfe von Sensorsystemen die Umgebung erfassen und aus der so erkannten Verkehrssituation automatische Reaktionen des Fahrzeugs ableiten und/oder den Fahrer instruieren, insbesondere warnen. Dabei unterscheidet man zwischen Komfort- und Sicherheitsfunktionen.

Als Komfortfunktion spielt in der momentanen Entwicklung FSRA (Full Speed Range Adaptive Cruise Control) die wichtigste Rolle. Das Fahrzeug regelt die Eigengeschwindigkeit auf die vom Fahrer vorgegebene Wunschgeschwindigkeit ein, sofern die Verkehrssituation dies zulässt, andernfalls wird die Eigengeschwindigkeit automatisch an die Verkehrssituation angepasst.

Neben einer Erhöhung des Komforts spielen Sicherheitsfunktionen eine immer größere Rolle, wobei Fokus auf der Reduzierung des Bremsweges in Notsituationen liegt. Das Spektrum der entsprechenden Fahrerassistenzfunktionen reicht von einem automatischen Vorfüllen der Bremse zur Reduktion der Bremslatenz (Prefill), über einen verbesserten Bremsassistenten (BAS+) bis hin zur autonomen Notbremsung.

Für Fahrerassistenzsysteme der oben beschriebenen Art werden heute vorwiegend Radarsensoren eingesetzt. Diese arbeiten auch bei schlechten Wetterbedingungen zuverlässig und können neben dem Abstand von Objekten auch direkt deren Relativgeschwindigkeit über den Dopplereffekt messen.

Für eine hohe Detektionsqualität sind die Ausgestaltung der Antenne sowie die Frequenzmodulation maßgebend. Beste Ergebnisse lassen sich dabei durch Antennenanordnungen mit mehreren Sende- und/oder Empfangsantennen und durch eine periodische Folge vieler linearer Frequenzrampen erzielen; die dabei anfallende hohe Datenmenge wird über eine mehrdimensionale Fouriertransformation prozessiert, wozu aber hohe Rechen- und Speicherkapazität benötigt wird. Durch die permanenten Weiterentwicklungen in der Halbleitertechnik reduzieren sich die Kosten für Rechenkapazität wegen höherer Takte und intelligenteren Implementierungen schneller als für Speicherkapazität, so dass der Anteil der Speicherkapazität an den Sensorkosten zunimmt.

**Aufgabe, Lösung und Vorteile der Erfindung**

Aufgabe der Erfindung ist es, die Speicherkapazität zu verringern, welche für die mehrdimensionale Fouriertransformation bei Antennenanordnungen mit mehreren Sende- und/oder Empfangsantennen und periodischer linearer Frequenzmodulation benötigt wird.

Diese Aufgabe wird grundsätzlich mit Hilfe eines Radarsystems gemäß den Ansprüchen 1-10 und eines Verfahrens gemäß den Ansprüchen 11-20 gelöst.

Die Vorteile der Erfindung ergeben sich aus reduzierten Kosten, reduzierter Chipgröße und reduzierter Leistungsaufnahme durch reduzierte Speichergröße. Umgekehrt kann man bei vorgegebener Speichergröße die Größe der mehrdimensionalen Fouriertransformation und damit das Auflösungsvermögen und/oder den Integrationsgewinn der Signalverarbeitung und damit die Sensorempfindlichkeit erhöhen.

Die WO 2010/115418 A2 offenbart ein Radarsystem zur Umfelderfassung, das derart ausgestaltet ist, dass zur Bestimmung der Relativgeschwindigkeit von Objekten und zur Erhöhung der Detektionsempfindlichkeit in einem Messzyklus pro Sendeantenne eine oder mehrere ineinander verschachtelte Folgen jeweils gleicher oder ähnlicher Einzelsignale abgestrahlt werden. Es sind Empfangsmittel vorgesehen, in denen die durch Reflektion an Objekten empfangenen Signale mit Hochfrequenzsignalen gemischt werden, wodurch niederfrequente Empfangssignale entstehen, welche Folgen von Einzelsignalen darstellen und über aufeinanderfolgende niederfrequente Einzelempfangssignale deren Phasenlage dadurch variiert wird, dass die Phasenlage der Einzelsendesignale und bzw. oder der zum Mischen benutzten Hochfrequenzsignale und bzw. oder der niederfrequenten Einzelempfangssignale selber variiert wird. WO2014029260 offenbart eine Daten Komprimierung und Dekomprimierung.

Bevorzugt umfasst das Radarsystem zur Umfelderfassung eines Kraftfahrzeugs Sendemitteln zur Abstrahlung von Sendesignalen mit einer oder mehreren Sendeantennen, Empfangsmitteln zum Empfang von an Objekten reflektierten Sendesignalen mit einer oder mehreren Empfangsantennen und Signalverarbeitungsmitteln zur Prozessierung der empfangenen Signale, wobei die Frequenz der abgestrahlten Sendeleistung derart moduliert ist, dass sie eine Folge von K linearer Rampen gleicher Steigung beinhaltet, die Empfangssignale mehrerer Kombinationen von Sende- und Empfangsantennen (z.B. i) eine Sendeantenne strahlt Sendeleistung ab und zumindest zwei Empfangsantennen empfangen die reflektierte Strahlung oder ii) n (n=1,2,....N) Sendeantennen strahlen Sendeleistung ab und eine oder mehrere Empfangsantennen empfangen Sendeleistung) durch Mischung mit einem Oszillatorsignal und Abtastung pro Frequenzrampe parallel und/oder über jeweils P aufeinanderfolgende Frequenzrampen (i. Folg. als Frequenzrampengruppe bezeichnet) seriell (also K/P-mal), akquiriert werden, in den digitalen Signalverarbeitungsmitteln Ergebnisse einer erste Spektralanalyse z.B. in Form einer diskreten Fouriertransformation (DFT) jeweils über die Abtastwerte pro Frequenzrampe und pro jeweiligen Kombinationen von Sende- und Empfangsantenne berechnet werden, über die K Frequenzrampen die Ergebnisse dieser ersten Spektralanalyse für zumindest einen Teil ihrer Frequenzstützstellen, welche sogenannte Entfernungstore darstellen, abgespeichert werden, danach über die pro Entfernungstor und pro Kombination von Sende- und Empfangsantenne über die Frequenzrampen und/oder Frequenzrampengruppen abgespeicherten Ergebnisse der ersten Spektralanalyse eine zweite Spektralanalyse z.B. in Form einer DFT berechnet wird, und Ergebnisse der zweiten Spektralanalyse über die verschiedenen Kombinationen von Sende- und Empfangsantennen weiter prozessiert werden, insbesondere mit Hilfe einer digitale Strahlformung über eine dritte Spektralanalyse, dadurch gekennzeichnet, dass die Ergebnisse der ersten Spektralanalyse zur Speicherplatzreduktion in komprimierter Form abgespeichert werden, wobei die Ergebnisse der ersten Spektralanalyse mehrerer Kombinationen von Sende- und Empfangsantenne pro Entfernungstor und Frequenzrampe und/oder Frequenzrampengruppe eine gleiche Skalierung erfahren und diese Skalierung mindestens einmal abgespeichert wird, die so skalierten Ergebnisse der ersten Spektralanalyse auf eine geringere Bitzahl als die in den Signalverarbeitungsmitteln, insbesondere bei den Spektralanalysen benutze Bitzahl quantisiert und mit dieser reduzierten Bitzahl abgespeichert werden, und diese komprimierten Ergebnisse der ersten Spektralanalyse vor der Berechnung der zweiten Spektralanalyse dekomprimiert werden.

Bevorzugt können die Signalverarbeitungsmittel eingerichtet sein, die Ergebnisse, insbesondere die Ergebnisse der Spektralanalysen, des Radarsystems in Festkommaarithmetik mit Zweierkomplementdarstellung zu berechnen.

Bevorzugt kann die gemeinsame Skalierung der Ergebnisse aus deren minimaler Anzahl von Bits mit jeweils gleichem Wert wie das oberste Bit bestimmt und zur Skalierung die so bestimmte Anzahl an Bits beginnend mit dem obersten Bit gestrichen werden.

Bevorzugt kann die gemeinsame Skalierung der Ergebnisse sowie die skalierten und auf die geringere Bitzahl quantisierten Ergebnisse in einem gemeinsamen binären Wort, dessen Bitanzahl vorzugsweise eine Zweierpotenz ist, codiert sein.

Bevorzugt kann für die in einem gemeinsamen binären Wort codierten skalierten Ergebnisse unterschiedliche Bitzahlen benutzt werden. In vorteilhafterweise kann bei Vorgabe einer Zweierpotenz für dessen Bitanzahl diese optimal ausgenutzt werden.

Bevorzugt kann vor der Quantisierung der skalierten Werte mindestens eine zufällige Zahl aufaddiert werden. In vorteilhafterweise können damit die Quantisierungsfehler über die Frequenzrampen bzw. Frequenzrampengruppen und/oder die verschiedenen Kombinationen von Sende- und Empfangsantenne annähernd entkorreliert werden.

Bevorzugt kann berücksichtigt sein, dass ein Stellenübertrag bei den Ergebnissen der ersten Spektralanalyse durch Addition einer zufälligen Zahl vor Quantisierung oder durch Rundung bei der Skalierung auftreten kann.

Bevorzugt können die Ergebnisse mehrerer Kombinationen von Sende- und Empfangsantennen für mehrere, vorzugsweise zwei benachbarte Entfernungstore pro Frequenzrampe bzw. Frequenzrampengruppe gleiche Skalierung aufweisen. In vorteilhafterweise braucht diese Skalierung deshalb nur mindestens einmal abgespeichert zu werden.

Bevorzugt kann in den digitalen Signalverarbeitungsmitteln eine unterschiedliche Sensitivität von verschiedenen Kombinationen von Sende- und Empfangsantenne vor der Komprimierung ausgeglichen werden.

Bevorzugt kann die diskreten Fouriertransformationen (DFTs) über eine schnelle Fouriertransformationen (FFTs) bestimmt werden.

Bevorzugt kann das Verfahren für ein Radarsystem zur Umfelderfassung eines Kraftfahrzeugs folgende Schritte aufweisen, Senden von Sendesignalen mit einer oder mehreren Sendeantennen, Empfangen von an Objekten reflektierten Sendesignalen mit einer oder mehreren Empfangsantennen und Prozessieren der empfangenen Signale, wobei die Frequenz der abgestrahlten Sendeleistung derart moduliert ist, dass sie eine Folge von K linearer Rampen gleicher Steigung beinhaltet, die Empfangssignale mehrerer Kombinationen von Sende- und Empfangsantennen (z.B. i) eine Sendeantenne strahlt Sendeleistung ab und zumindest zwei Empfangsantennen empfangen die reflektierte Strahlung oder ii) n (n=1,2,....N) Sendeantennen strahlen Sendeleistung ab und eine oder mehrere Empfangsantennen empfangen Sendeleistung) durch Mischung mit einem Oszillatorsignal und Abtastung pro Frequenzrampe parallel und/oder über jeweils P aufeinanderfolgende Frequenzrampen, die eine Frequenzrampengruppe bilden, seriell (also K/P-mal) akquiriert werden, Ergebnisse einer erste Spektralanalyse z.B. in Form einer diskreten Fouriertransformation (DFT) jeweils über die Abtastwerte pro Frequenzrampe und pro jeweiligen Kombinationen von Sende- und Empfangsantenne berechnet werden, über die K Frequenzrampen die Ergebnisse dieser ersten Spektralanalyse für zumindest einen Teil ihrer Frequenzstützstellen, welche sogenannte Entfernungstore darstellen, abgespeichert werden, danach über die pro Entfernungstor und pro Kombination von Sende- und Empfangsantenne über die Frequenzrampen und/oder Frequenzrampengruppen abgespeicherten Ergebnisseder ersten Spektralanalyse eine zweite Spektralanalyse z.B. in Form einer DFT berechnet wird, und die Ergebnisse der zweiten Spektralanalyse über die verschiedenen Kombinationen von Sende- und Empfangsantennen weiter prozessiert werden (z.B. mit Hilfe einer digitale Strahlformung über eine dritte DFT),

dadurch gekennzeichnet, dass die Ergebnisse der ersten Spektralanalyse zur Speicherplatzreduktion in komprimierter Form abgespeichert werden, wobei die Ergebnisse der ersten Spektralanalyse mehrerer Kombinationen von Sende- und Empfangsantenne pro Entfernungstor und Frequenzrampe und/oder Frequenzrampengruppe eine gleiche Skalierung erfahren und diese Skalierung mindestens einmal abgespeichert wird, die so skalierten Ergebnisse der ersten Spektralanalyse auf eine geringere Bitzahl als die beim Prozessieren (insbesondere bei den Spektralanalysen) benutze Bitzahl quantisiert und mit dieser reduzierten Bitzahl abgespeichert werden, und diese komprimierten Ergebnisse der ersten Spektralanalyse vor der Weiterverarbeitung, insbesondere vor der zweiten Spektralanalyse, wieder dekomprimiert werden, umfassen.

## Kurzbeschreibung der Zeichnungen

Fig. 1 zeigt die beispielhaft betrachtete Ausführungsform des Radarsystems.

Fig. 2 zeigt die Frequenz der Sende- und der Empfangssignale, welche aus sogenannten Frequenzrampen besteht.

Fig. 3 zeigt ein abgetastetes Signal bei Anwesenheit von zwei Objekten vor der ersten DFT (links) und nach der ersten DFT (rechts).

In Fig. 4 ist der über die Frequenzrampen rotierende komplexe Spektralwert im Entfernungstor 4, in welchem sich genau ein Objekt befindet, dargestellt.

Fig. 5 zeigt das zweidimensionale komplexwertige Spektrum nach der zweiten DFT.

Fig. 6 erläutert die unterschiedlichen Phasenlagen an den vier Empfangsantennen und ihren Zusammenhang mit dem Azimutwinkel.

Fig. 7 zeigt die Daten vor der dreidimensionalen DFT (links) und das dreidimensionale komplexwertige Spektrum danach (rechts).

## Ausführungsbeispiel

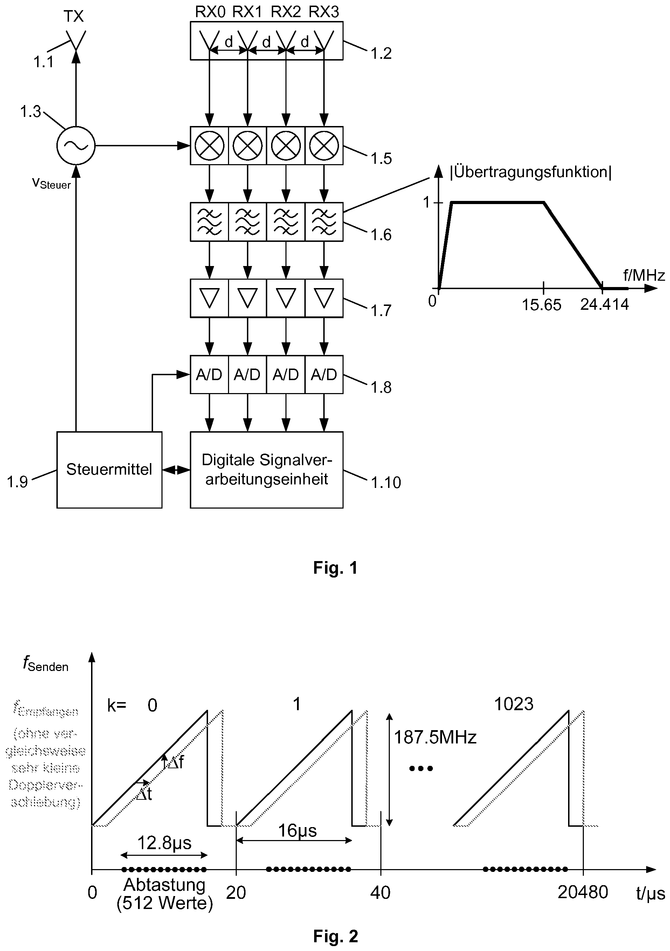

Betrachtet wird die beispielhafte Ausführung eines Radarsystems, welches in Fig. 1 grob dargestellt ist. Das Radarsystem besitzt eine Sendeantenne 1.1 zur Abstrahlung von Sendesignalen und eine Mehrzahl von Empfangsantennen insbesondere wie dargestellt vier Empfangsantennen 1.2 zum gleichzeitigen Empfang von an Objekten reflektierten Sendesignalen. Alle Antennen (Sende- und Empfangsantennen) haben in Elevation und Azimut dieselbe Strahlform. Die Mehrzahl von Empfangsantennen befinden sich in einer Ebene und haben jeweils gleichen lateralen, d. h. horizontalen Abstand d.

Die Sendesignale werden aus dem Hochfrequenz-Oszillator 1.3 im GHz-Bereich insbesondere im 24GHz-Bereich gewonnen, welcher über eine Steuerspannung $v_{Steuer}$ in seiner Frequenz verändert werden kann; die Steuerspannung wird in den Steuermitteln 1.9 erzeugt. Die von den Antennen empfangenen Signale werden in den reellwertigen Mischern 1.5 ebenfalls mit dem Signal des Oszillators 1.3 in den Niederfrequenzbereich heruntergemischt. Danach durchlaufen die Empfangssignale jeweils ein Bandpassfilter 1.6 mit der dargestellten Übertragungsfunktion, einen Verstärker 1.7 und einen A/D-Wandler 1.8; anschließend werden sie in einer digitalen Signalverarbeitungseinheit 1.10 weiterverarbeitet.

Damit die Entfernung von Objekten gemessen werden kann, wird - wie in Fig. 2 dargestellt - die Frequenz des Hochfrequenz-Oszillators und damit der Sendesignale sehr schnell linear verändert (z.B. in 16$\mu$s um 187.5MHz); man spricht dabei von einer Frequenzrampe. Die Frequenzrampen werden periodisch wiederholt (z.B. alle 20$\mu$s); insgesamt gibt es z.B. 1024 Frequenzrampen.

Das Empfangssignal eines einzelnen Objekts ist nach Mischung und damit auch am A/D-Wandler für jede Frequenzrampe und jeden der Mehrzahl von Empfangskanälen eine sinusförmige Schwingung; dies kann man sich mit Hilfe von Fig. 2 wie folgt erklären: Hat das Objekt die radiale Relativgeschwindigkeit Null zum Radarsystem, so ist die Frequenzdifferenz $\Delta f$ zwischen gesendetem Signal und empfangenem Signal konstant und dabei proportional zur Signallaufzeit $\Delta t$ und damit proportional zur radialen Entfernung $\Delta r = c \cdot \Delta t / 2$, wobei c die Lichtgeschwindigkeit ist und der Faktor 1/2 berücksichtigt, dass sich die Laufzeit $\Delta t$ auf das Hin- und Zurücklaufen der Welle bezieht; die Frequenzdifferenz $\Delta f$ ergibt sich bei dem oben genannten Zahlenbeispiel zu $\Delta f = 2r/c \cdot 187.5 \text{MHz}/16\mu s = r \cdot 78.125 \text{kHz/m}$. Da das empfangene Signal in jedem Empfangskanal mit der Oszillator- und damit der Sendefrequenz gemischt wird, ergibt sich nach dem Mischer jeweils eine sinusförmige Schwingung mit der Frequenz $\Delta$f. Diese Frequenz liegt im MHz-Bereich und wird bei einer nichtverschwindenden (radialen) Relativgeschwindigkeit noch um die Dopplerfrequenz verschoben, welche aber nur im kHz-Bereich liegt und deshalb gegenüber dem Frequenzanteil durch die Objektentfernung näherungsweise vernachlässigbar ist. Gibt es mehrere Objekte, so ist das Empfangssignal eine Überlagerung mehrerer sinusförmiger Schwingungen unterschiedlicher Frequenz.

Während jeder Frequenzrampe werden in allen Empfangskanälen die Empfangssignale am A/D-Wandler z.B. 512 mal jeweils im Abstand von z. B. 25ns (also mit 40 MHz) abgetastet (siehe Fig. 2). Wie aus Fig. 2 ersichtlich ist, macht eine Signalabtastung nur in dem Zeitbereich Sinn, wo Empfangssignale von Objekten im interessierenden Entfernungsbereich eintreffen - nach Rampenstart muss also wenigstens die zur maximal interessierenden Entfernung korrespondierende Laufzeit abgewartet werden (bei einer maximalen Entfernung von 200m entspricht dies 1.25$\mu$s).

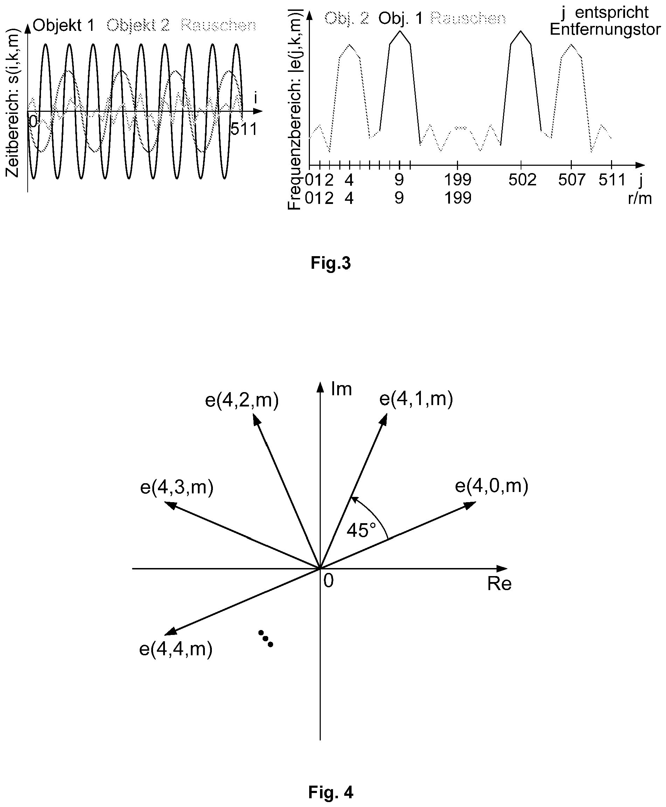

Dann wird über die z.B. 512 Abtastwerte jeder Frequenzrampe und jedes Empfangskanals eine diskrete Fouriertransformation (DFT) in Form einer schnellen Fouriertransformation (FFT = Fast Fourier Transform) gebildet. Dadurch kann man Objekte in unterschiedlichen Entfernungen, welche zu unterschiedlichen Frequenzen führen, trennen (siehe Fig. 3; links Signal vor DFT bei Anwesenheit von zwei Objekten, rechts nach DFT; dabei ist k die Laufvariable über die z.B. 1024 Frequenzrampen und m die Laufvariable über die Mehrzahl von Empfangskanälen RXm). Jede der diskreten Frequenzstützstellen j der DFT korrespondiert zu einer Entfernung r und kann deshalb analog zu Pulsradaren auch als Entfernungstor bezeichnet werden; bei obiger Auslegung haben die Entfernungstore gerade einen Abstand und damit eine Breite von z.B. einem Meter (ergibt sich mit den oben genannten Zahlenbeispielen aus r·78.125kHz/m = 1/(12.8$\mu$s)). In den Entfernungstoren, in welchen sich Objekte befinden, treten in der DFT Leistungsspitzen auf. Da die abgetasteten Empfangssignale reellwertig sind und der obere Übergangsbereich der analogen Bandpassfilter 1.5 eine Frequenzbandbreite von z. B. 8.764MHz hat (entspricht dem Bereich von 112 Frequenzstützstellen), können nur z.B. 200 der 512 diskreten Frequenzstützstellen weiterverarbeitet werden (es sei bemerkt, dass beliebig schmale Übergangsbereiche von Filtern nicht realisierbar sind). Die Filter 1.5 dämpfen kleine Frequenzen und somit die Empfangssignale von nahen Objekten, um eine Übersteuerung der Verstärker 1.6 und der A/D-Wandler 1.7 zu vermeiden (die an den Antennen empfangenen Signale werden mit abnehmendem Objektabstand ja stärker).

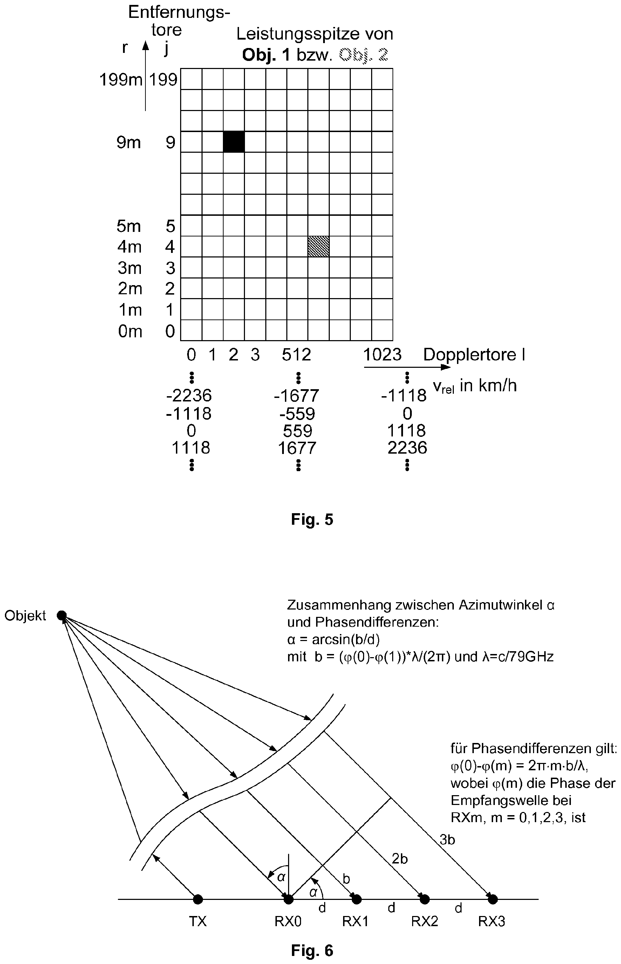

Über die z.B. 1024 Frequenzrampen (k = 0,1,...,1023) fallen in jedem Empfangskanal m (m=0,1,2,3) für jedes Entfernungstor j (z.B. also jede der 200 betrachteten Frequenzstützstellen) komplexe Spektralwerte e(j,k,m) an. Gibt es in der zu einem Entfernungstor korrespondierenden Entfernung genau ein Objekt, so rotiert der komplexe Spektralwert in diesem Entfernungstor j über die z.B. 1024 Frequenzrampen mit der Dopplerfrequenz, da sich von Frequenzrampe zu Frequenzrampe die Entfernung (im mm-Bereich oder darunter) und damit die Phasenlage der zugehörigen Schwingung gleichförmig ändert (siehe Fig. 4; die dort dargestellte Phasenänderung von 45° pro Frequenzrampe korrespondiert zu einer Entfernungsänderung des Objekts von $\lambda/(8\cdot2) = 0.78$mm, wobei die Wellenlänge $\lambda$ = c/24.15GHz = 12.4mm ist und der Faktor 2 im Nenner das Hin- und Zurücklaufen der Wellen berücksichtigt, woraus sich die Relativgeschwindigkeit $v_{rel}$ = 0.78mm/20$\mu$s = 140km/h ergibt). Mehrere Objekte mit unterschiedlicher Relativgeschwindigkeit im selben Entfernungstor werden dadurch getrennt, dass für jeden Empfangskanal und jedes Entfernungstor über die in den z.B. 1024 Frequenzrampen anfallenden komplexen Spektralwerte eine zweite DFT gerechnet wird. Jede diskrete Frequenzstützstelle l dieser zweiten DFT korrespondiert zu einem Satz von Dopplerfrequenzen (wegen der Abtastung der Dopplerfrequenz kann sie nur bis auf ein unbekanntes ganzzahliges Vielfaches ihrer Abtastfrequenz bestimmt werden) und somit einem Satz von Relativgeschwindigkeiten $v_{rel}$ von Objekten, so dass die diskreten Frequenzstützstellen der zweiten DFT als Relativgeschwindigkeitstore bezeichnet werden können (bei der hier betrachteten beispielhaften Auslegung gibt es aus dem Satz möglicher Relativgeschwindigkeiten immer nur eine für den Straßenverkehr sinnvolle bzw. mögliche - siehe Fig. 5). Die zweite DFT dient nicht nur zur Ermittlung der Relativgeschwindigkeit, sondern sie erhöht durch ihre Integration auch die Detektionsempfindlichkeit - bei 1024 Frequenzrampen etwa um 10·log$_{10}$(1024) = 30dB.

Nach dieser zweiten DFT für die Relativgeschwindigkeiten ergibt sich für jeden Empfangskanal ein zweidimensionales komplexwertiges Spektrum, wobei die einzelnen Zellen als Entfernung-Relativgeschwindigkeit-Tore bezeichnet werden können und durch Objekte Leistungsspitzen am jeweils zugehörigen Entfernung-Relativgeschwindigkeit-Tor auftreten (siehe Fig. 5).

Schließlich wird dann noch die Information aus der Mehrzahl von Empfangskanälen (zu der Mehrzahl von Empfangsantennen) fusioniert. Die von der Sendeantenne stammende, an einem einzelnen Objekt reflektierte Welle kommt an den z.B. vier Empfangsantennen m, m=0,1,2,3, abhängig vom Azimutwinkel $\alpha$ mit unterschiedlichen Phasenlagen $\varphi$(m) an, da die Entfernungen zwischen Objekt und Empfangsantennen leicht unterschiedlich sind; wegen der horizontalen Äquidistanz der Empfangsantennen nehmen die Phasenunterschiede über die vier Empfangsantennen linear zu bzw. ab (siehe Fig. 6). Eventuell abgesehen von konstanten und damit kompensierbaren Phasenverschiebungen bleiben diese Phasenunterschiede bis nach der zweiten DFT erhalten, so dass man über die vier Empfangskanäle in jedem Entfernung-Relativgeschwindigkeit-Tor eine digitale Strahlformung durchführen kann. Dazu bildet man Summen über die komplexen Werte der vier Empfangskanäle, welche jeweils mit einem Satz komplexer Faktoren mit linear zunehmender Phase multipliziert werden; abhängig von der linearen Phasenänderung des jeweiligen Faktorensatzes resultieren Strahlungskeulen mit unterschiedlichen Strahlrichtungen. Die Strahlbreite dieser Strahlungskeulen ist deutlich geringer als diejenige der einzelnen Empfangsantennen. Die oben beschrieben Summation wird durch eine 8-Punkte-DFT realisiert, wobei die z.B. vier Werte der z.B. vier Empfangskanäle durch vier Nullen ergänzt werden; die diskreten Frequenzwerte dieser DFT korrespondieren zu unterschiedlichen Azimutwinkeln und können deshalb als Winkeltore n (z.B. n= 0,1,....7) bezeichnet werden.

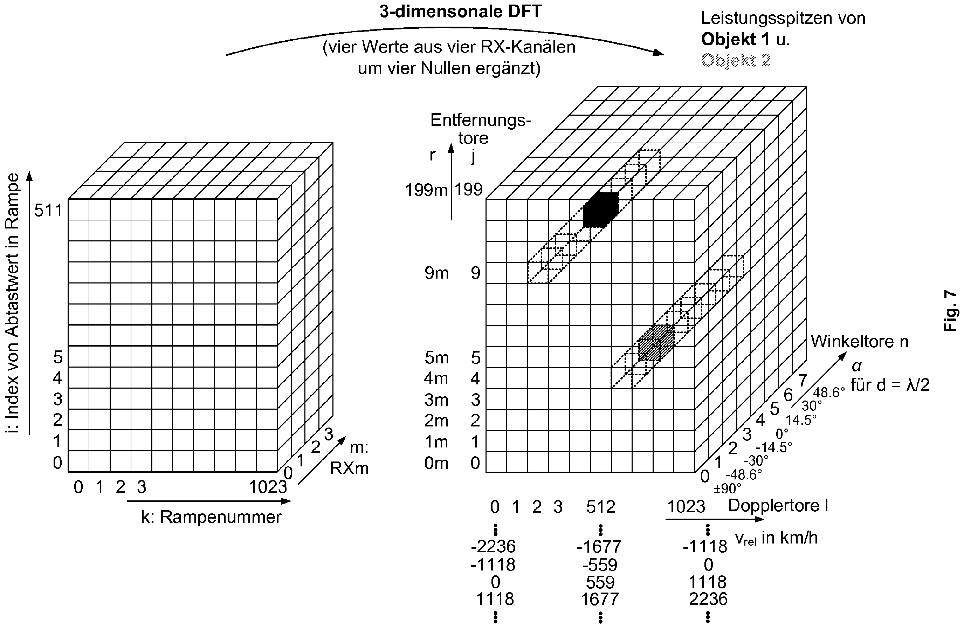

Nach dieser dritten DFT für die Azimutwinkel ergibt sich ein dreidimensionales komplexwertiges Spektrum, wobei die einzelnen Zellen als Entfernung-Relativgeschwindigkeit-Winkel-Tore bezeichnet werden können und durch Objekte Leistungsspitzen am jeweils zugehörigen Entfernung-Relativgeschwindigkeit-Winkel-Tor auftreten (siehe Fig. 7; links Daten vor dreidimensionaler DFT, rechts danach). Durch Bestimmung der Leistungsspitzen kann man also Objekte detektieren und ihre Maße Entfernung, Relativgeschwindigkeit (abgesehen von eventuellen Mehrdeutigkeiten, s. o.) und Azimutwinkel ermitteln. Da Leistungsspitzen bedingt durch die DFT-Fensterungen auch in benachbarten Zellen noch Pegel aufweisen, kann man die Objektmaße durch Interpolation in Abhängigkeit dieser Pegel noch wesentlich genauer als die Torbreiten bestimmen. Es sei bemerkt, dass die Fensterfunktionen der drei DFTs so gewählt werden, dass einerseits die Leistungsspitzen nicht zu breit werden (für eine genügende Objekttrennung), aber andererseits auch die Nebenkeulen der Fensterspektren nicht zu hoch werden (um auch schwach reflektierende Objekte in Anwesenheit stark reflektierender Objekte erkennen zu können). Aus der Höhe der Leistungsspitzen kann als viertes Objektmaß noch dessen Reflektionsquerschnitt geschätzt werden, welcher angibt, wie stark das Objekt die Radarwellen reflektiert. Die beschriebene Detektion von Objekten und die Bestimmung der zugehörigen Objektmaße stellen einen Messzyklus dar und liefern ein Momentanbild des Umfeldes; dies wird z.B. etwa alle 30ms zyklisch wiederholt.

Das oben beschriebene Verfahren hat den Vorteil einer hohen Auflösungs- und damit Zieltrennfähigkeit, da die Messgrößen Entfernung, Relativgeschwindigkeit und Azimutwinkel zum einen unabhängig voneinander und zum anderen in hoher Auflösung ermittelt werden. Nachteilig ist, dass große Datenmengen verarbeitet werden müssen, was hohe Rechen- und Speicherkapazität benötigt. Durch die permanenten Weiterentwicklungen in der Halbleitertechnik reduzieren sich die Kosten für Rechenkapazität wegen höherer Takte und intelligenteren Implementierungen schneller als für Speicherkapazität. Deshalb ist es sehr wichtig, dass man das oben beschriebene Verfahren optimal hinsichtlich Speicherbedarf auslegt.

Bevor man die zweite und dritte DFT für die Relativgeschwindigkeiten und Azimutwinkel berechnet, muss man für alle z.B. 1024 Frequenzrampen und z.B. 4 Empfangskanäle die erste DFT für die z.B. 200 Entfernungstore bestimmt haben. Die in diesem Beispiel verwendete digitale Signalverarbeitungseinheit 1.10 rechnet in 32Bit-Festkommaarithmetik in Zweierkomplementdarstellung. Damit benötigt man pro komplexwertigem Wert 8 Byte (2mal 32Bit, wobei 1Byte = 8Bit ist). Über die z.B. 1024 Frequenzrampen, z.B. 4 Empfangskanäle und z.B. 200 Entfernungstore fallen also 1024x4x200x8 = 6.553.600Byte Daten an. Der dazu benötigte Speicher würde Kosten von einigen Euro verursachen.

Deshalb wird hier eine Komprimierung der Daten nach der ersten DFT für die Entfernungsmessung durchgeführt. Dazu überführt man die Ergebnisse der ersten DFT in eine sogenannte Pseudo-Gleitkomma-Darstellung, welche nachfolgend erläutert wird:

Pro Frequenzrampe fallen nach der ersten DFT in jedem Entfernungstor über die z.B. 4 Empfangskanäle gesehen z.B. 8 reellwertige Zahlen mit 32Bit an (4 Realteile und 4 Imaginärteile - die Werte nach der ersten DFT sind ja komplexwertig). Über diese z.B. 8 32Bit-Festkommawerte in Zweierkomplementarithmetik bestimmt man nun jeweils, wie viele Bits nach dem obersten Bit gleichen Wert wie dieses haben bevor zum ersten Mal ein Bit mit anderem Wert kommt (oberstes Bit wird auch MSB = Most Significant Bit genannt und trägt bei Zweierkomplementdarstellung die Vorzeicheninformation): für das Beispiel 11111110101110000000010000010111 gibt es nach dem MSB mit Wert Eins insgesamt 6 weitere Einsen, bevor die erste Null kommt. Aus diesen 8 Anzahlen an nachfolgenden gleichwertigen Bits wie MSB bestimmt man das Minimum, welches als Blockshift bezeichnet wird. Im nachfolgenden Beispiel der 8 32Bit-Zahlen:

```
11111110101110000000010000010111
11111111110100101000101110100101
00000000101010000101000100010010
11111011100010101000001000010001
00000101010100000111101010101010
11111111010101000000101010010100
00000000100001010010100001001010
11111101010010100001010010000001
```

ergibt sich also ein Blockshift von 4 (von vierter und fünfter Zahl, bei welchen es nach dem MSB nur 4 Bits mit gleichem Wert wie MSB gibt). Diesen Blockshift kodiert man binär in 8 Bits, also im Beispiel oben zu 00000100.

Für jede der 32Bit-Zahlen streicht man dann die ersten Blockshift (also im Beispiel oben 4) Bits und extrahiert die nächsten 7Bits, welche man auch als Mantisse bezeichnen kann; falls der Blockshift größer als 25 ist, sind dabei die 32Bit-Zahlen hinten noch mit Nullen zu erweitern. Diese 8 Mantissen zu je 7Bits werden an die 8Bit vom Blockshift angehängt, wodurch man einen 64Bit-Wert in sogenannter Pseudo-Gleitkomma-Darstellung bekommt; im Beispiel oben ergibt sich (die Punkte trennen zur besseren Visualisierung die einzelnen Anteile):

00000100.1110101.1111110.0000101.1011100.0101010.1111010.0000100.110101 0

Dieser Vorgang stellt also eine einheitliche Skalierung der 8 Werte auf den Blockshift und eine Quantisierung der skalierten Werte auf 7Bit dar.

Es sei bemerkt, dass 5Bits für die Darstellung des Blockshift von 32Bit-Zahlen ausreichen würden; er wurde im Beispiel oben nur zu 8Bit "erweitert", um insgesamt auf 64Bit zu kommen, da in Speichern üblicherweise benutzte Bitzahlen Zweierpotenzen sind. Man könnte diese drei unbenutzten Bits natürlich auch an anderer Stelle einfügen.

Um für die komprimierten Werte möglichst wenige Bits zu benötigen, ist für alle 4 komplexen Kanalwerte derselbe Blockshift, also dieselbe Skalierung für die Pseudo-Gleitkomma-Darstellung benutzt worden. Da alle Empfangskanäle dieselben Ziele sehen, haben sie zumindest in Situationen mit nur einem Ziel im jeweiligen Entfernungstor denselben Pegel, so dass durch die gleiche Skalierung aller Empfangskanäle kein oder höchstens nur ein leicht höherer Quantsierungsfehler als bei Vorhalt von separaten Skalierungswerten für die z.B. 4 komplexen Empfangskanalwerte oder deren insgesamt 8 reellwertigen Anteile (Real- und Imaginärteile) entsteht. Die obige Aussage, dass zumindest in Situationen mit nur einem Ziel im jeweiligen Entfernungstor die Empfangskanäle denselben Pegel aufweisen, gilt nur dann, wenn sie dieselbe Sensitivität haben. Falls die analogen Teile der Empfangskanäle unterschiedliche Sensitivität haben (z.B. weil die Leitungen zwischen Empfangsantennen und Mischern unterschiedlich lang sind), kann das in der digitalen Signalverarbeitung z.B. vor der ersten DFT durch Multiplikation mit unterschiedlichen Faktoren ausgeglichen werden.

Die oben beschriebene Komprimierung der z.B. 4 komplexen Empfangskanalwerte auf 64Bit wird für jede der z.B. 1024 Frequenzrampen und jedes der z.B. 200 Entfernungstore durchgeführt. Damit werden nur noch 1.638.400Byte Speicher benötigt, was eine Reduktion um 75% darstellt.

Nachdem über alle Frequenzrampen die erste FFT bestimmt und die Ergebnisse wie oben dargestellt in komprimierter Pseudo-Gleitkomma-Darstellung abgespeichert worden sind, werden nacheinander für jedes Entfernungstor die zweite und dritte DFT für die Relativgeschwindigkeiten und Azimutwinkel berechnet und die Leistungsspitzen über diese zwei Dimensionen bestimmt und abgespeichert.

Da diese Berechnungen wieder in 32Bit-Festkommaarithmetik in Zweierkomplementdarstellung durchgeführt werden, sind die nach der ersten DFT komprimierten Daten wieder zu "entpacken", also zu dekomprimieren, was im Folgenden beschrieben wird: Für das jeweilige Entfernungstor werden die auf jeweils 64Bit komprimierten Daten der z.B. 1024 Frequenzrampen nacheinander ausgelesen. Diese 64Bit-Zahlen enthalten die 4 Real- und 4 Imaginärteile der 4 Empfangskanäle als 7Bit-Mantissen und mit einem gemeinsamen 8Bit-Blockshift. Um daraus 32Bit-Festkommawerte zu bilden, fügt man vor den Mantissen Blockshift-mal (also im Beispiel oben 4mal) deren oberstes Bit an und füllt hinter der Mantisse mit Nullen auf 32Bit auf; falls der Blockshift größer als 25 ist, entfallen die hinteren Bits der Mantisse (welche ohnehin dann Null sind). Im Beispiel oben bekommt man dann folgende 8 reellwertigen 32Bit-Zahlen (die Punkte visualisieren die Lage der Mantisse):

1111.1110101.00000000000000000000
1111.1111110.00000000000000000000
0000.0000101.00000000000000000000
1111.1011100.00000000000000000000
0000.0101010.00000000000000000000
1111.1111010.00000000000000000000
0000.0000100.00000000000000000000
1111.1101010.00000000000000000000

Die ersten 11 Bits der Werte sind identisch zu den ursprünglichen Werten, die nachfolgenden 21 Bits sind zu Null gesetzt und damit unterschiedlich zu den ursprünglichen Werten.

Das beschriebene Verfahren bestimmt die Leistungsspitzen zuerst über die Dimensionen Relativgeschwindigkeit und Azimutwinkel, also pro Entfernungstor, und speichert diese ab. Nachdem so über alle Entfernungstore Leistungsspitzen gebildet und abgespeichert worden sind, werden in einem abschließenden Schritt noch über die dritte Dimension Entfernung die Leistungsspitzen final bestimmt.

Der für das Zwischenspeichern der Leistungsspitzen pro Entfernungstor benötigte Speicher ist viel geringer als der für die Ergebnisse nach der ersten DFT benötigte Speicher, da es höchstens einige Hundert Reflektionspunkte gibt. Damit liegt die Hauptspeicherlast beim hier beschriebenen Radarverfahren auf den Daten nach der ersten DFT, deren Umfang durch den beschriebenen Kompensationsmechanismus um 75% reduziert werden konnte.

Bei der Komprimierung geht der Informationsgehalt der hinter der Mantisse abgeschnittenen Bits verloren. Durch diese Quantisierung macht man also einen Fehler. Beim oben beschriebenen Vorgehen wird einfach abgeschnitten, also nicht gerundet. Dadurch macht man im Mittel einen Fehler der Hälfte des niederwertigsten Bits (LSB = Least Significant Bit) der Mantisse.

Durch Runden statt Abscheiden lässt sich dieser mittlere Fehler vermeiden. Das Runden kann man dadurch realisieren, dass man einen Wert mit der Hälfte des Mantissen-LSBs vor Abschneiden addiert, also im Beispiel oben (die Punkte visualisieren die Lage der Mantisse):

0000.0000000.10000000000000000000

Auf jeweils ein Entfernungstor bezogen sind die Fehler, welche man durch die Quantisierung bei der Komprimierung macht, über alle Frequenzrampen gesehen typischerweise etwa gleich groß. Grund dafür ist, dass man in einem Entfernungstor ja über alle insgesamt 20.48ms dauernden Frequenzrampen dieselben Ziele detektiert (sofern deren Relativgeschwindigkeit nicht extrem hoch ist) und sich deren Pegel in dieser Zeit kaum ändert, so dass der Blockshift in einem Entfernungstor über alle Frequenzrampen etwa gleich groß ist. Sofern der Quantisierungsfehler über die Frequenzrampen zufällig, also unkorreliert ist, integriert er sich bei der zweiten DFT über die z.B. 1024 Frequenzrampen nicht kohärent auf; dadurch erhöht sich der Abstand der Signalleistung zur Quantisierungsrauschleistung nach der zweiten DFT um z.B. $10 \cdot \log_{10}(1024) = 30 dB$. Bei der dritten DFT über die vier Empfangskanäle gewinnt man z.B. weitere $10 \cdot \log_{10}(4) = 6 dB$, sofern der Quantisierungsfehler über die Empfangskanäle unkorreliert ist.

Damit erhöht sich der Dynamikbereich der Quantisierung der Komprimierung um 6Bit (1Bit entspricht 6dB; insgesamt 36dB Integrationsgewinn), d.h., zu den 7 Bit der Mantisse kommen über den Integrationsgewinn der zweiten und dritten DFT nochmal 6Bit dazu.

Dieser Dynamikbereich von grob 13Bit innerhalb eines Entfernungstor bezogen auf das dort stärkste Ziel ist mehr als ausreichend, da ein stark reflektierendes Ziel ohnehin im selben Entfernungstor durch nicht ideale Hardware-Eigenschaften (wie z.B. Phasenrauschen des Oszillators) und andere Signalverarbeitungsartefakte (wie Nebenkeulen der Spektren der Fensterfunktionen der DFT) den Dynamikbereich reduziert und so extrem schwach reflektierende Ziele unsichtbar machen kann.

Über alle Entfernungen bezogen braucht man natürlich einen größeren Dynamikbereich, insbesondere, da nahe Ziele viel größeren Pegel als ferne Ziele haben. Dem steht die Quantisierung der Komprimierung aber nicht entgegen, da sie nur innerhalb jeweils eines Entfernungstors den Dynamikbereich quasi adaptiv einschränkt.

Deshalb und wegen dem Integrationsgewinn der zweiten und dritten DFT kann man die Länge der Mantisse bei der Komprimierung viel kleiner halten als die bei der Berechnung der drei DFTs benutze Zahlenlänge (hier 32Bit) und so Speicherkapazität sparen.

Wie oben schon einschränkend erwähnt, hat man für das Quantisierungsrauschen der Komprimierung den Integrationsgewinn der zweiten und dritten DFT nur, wenn das Quantisierungsrauschen über die Frequenzrampen und Empfangskanäle hinweg unkorreliert ist (über die Entfernungstore hinweg braucht es das nicht zu sein). Wenn nun - wie im Falle großer Reflektionen gegeben - das Quantisierungsrauschen das Systemrauschen durch die Hardware (Rauschen der analogen Teile) übersteigt, dann ist diese Unkorreliertheit im Allgemeinen nicht gegeben, was z.B. zu nicht realen Leistungsspitzen nach der dreidimensionalen DFT führen könnte, also schlussendlich zu sogenannten Geisterdetektionen im Radarbild. Deshalb ist es vorteilhaft, vor dem Quantisieren (also Extrahieren der Mantisse) so viel Rauschen aufzuaddieren, dass Unkorreliertheit intrinsisch garantiert ist. Dazu wird jeweils eine zufällige Zahl, welche sich über die später abgeschnittenen Bits erstreckt, aufaddiert; sie nimmt also einen zufälligen Wert aus Intervall [0, Mantissen-LSB[an. Über die Frequenzrampen und Empfangskanäle hinweg, ist diese Zufallszahl unkorreliert, über die Entfernungstore hinweg kann sie gleich sein. Im Beispiel oben soll nun die erste der 8 reellwertigen Zahlen betrachtet werden, zu der vor Extrahieren der Mantisse eine entsprechende zufällige Zahl addiert wird (die die Punkte visualisieren die Lage der Mantisse):

$$1111.1110101.110000000010000010111$$
$$+ \quad 101011110010001010000$$

$$1111.1110110.0110111101000011100111$$

Damit ändert sich die Mantisse von 1110101 zu 1110110.

Durch dieses Addieren einer zufälligen Zahl (wie auch durch das weiter oben beschrieben Addieren eines halben Mantissen-LSBs für Runden statt Abschneiden) könnte es zu einem Überlaufen der Mantisse kommen (für Mantisse 0111111), also dass oberstes Bit der Mantisse nicht mehr gleich oberstes Bit der ursprünglichen Zahl ist, so dass sich der Blockshift erniedrigt. Dieser Fall ist entsprechend abzufangen, z.B. dadurch, dass man bei Vorhandensein einer ursprünglichen Mantisse 0111111 proaktiv den Blockshift um eins erniedrigt.

Es sei bemerkt, dass die Länge der aufaddierten zufälligen Zahl z.B. auf 8Bit reduziert werden kann, da die Quantisierungsfehler dann immer noch ausreichend unkorreliert sind.

Abschließend sei erwähnt, dass sich die oben erläuterte Datenkomprimierung natürlich auch auf andere Systemarchitekturen übertragen und/oder mit alternativen Ausprägungen implementieren lässt; hier seien noch einige Beispiele genannt:

•    bisher wurde eine parallele Erfassung der Daten aller z.B. 4 Empfangskanäle betrachtet; zur Reduzierung der benötigten Hardware kann man nach den Mischern auch eine Multiplexer einfügen, so dass der niederfrequente Teil der Empfänger bis einschließlich des A/D-Wandlers statt vierfach nur noch einfach ausgeführt werden muss; dann werden pro Frequenzrampe alternierend nur noch die Daten jeweils eines Empfangskanals erfasst: bei Frequenzrampen 1,5,9,... für Empfangskanal 1, bei Frequenzrampen 2,6,10,... für Empfangskanal 2, ...; pro Entfernungstor werden dann die Daten von jeweils vier aufeinanderfolgenden Frequenzrampen für die vier Empfangskanäle zusammengefasst, also Daten der Frequenzrampengruppen 1-4, 5-9, ...,

- die eben beschriebene serielle Datenerfassung von Empfangskanälen kann man auch auf ein Radarsystem mit einer Empfangsantenne und mehreren Sendeantennen analog übertragen; des weiteren kann man die Komprimierung auch auf parallel über mehrere Empfangsantennen und seriell über mehrere Sendeantennen erfasste Daten anwenden,

- die Quantisierungsfehler der Komprimierung sind im Allgemeinen auch noch bei signifikant geringerer Mantissenlänge klein genug; z.B. kann bei einer 16Bit-Signalverarbeitung und bei 6 Empfangskanälen eine 64Bit-Komprimierung mit 4Bit-Blockshift und 5Bit-Mantissenlänge für die zusammen 12 Real- und Imaginärteile implementiert werden,

- auch wenn die Signalverarbeitung mit mehr als 16Bit arbeitet (z.B. mit 24Bit), kann man einen 4Bit-Blockshift verwenden, da die erste DFT normalerweise noch nicht die volle Dynamik der Signalverarbeitung benötigt (volle Dynamik wird erst durch den weiteren Signalverarbeitungsgewinn der zweiten und dritten DFT benötigt); der Blockshift ist dann eben auf maximal 15 zu begrenzen,

- insbesondere, um für den Blockshift und die Mantissen zusammen auf eine Bitanzahl gleich einer Zweierpotenz zu kommen (so sind Speicher üblicherweise ausgelegt), kann es Sinn machen, nicht alle Mantissen gleich lang zu machen; z.B. kann bei einer 16Bit-Signalverarbeitung und bei 4 Empfangskanälen eine 32Bit-Komprimierung mit 4Bit-Blockshift, 4Bit-Mantissenlänge für die 4 Realteile und 3Bit-Mantissenlänge für die 4 Imaginärteile erreicht werden,

- bisher wurde betrachtet, das die Daten der Empfangskanäle jeweils pro einem Entfernungstor gemeinsam komprimiert werden - also mit gleicher Skalierung; man könnte nun aber auch für mehrere, insbesondere zwei benachbarte Entfernungstore gleiche Skalierung benutzen, da deren Pegel im Allgemeinen nicht sehr stark unterschiedlich ist (wegen Verschleifung des Spektrums durch die Fensterfunktion) und weil für die weitere Prozessierung hauptsächlich wichtig ist, dass die Entfernungstore mit einer Leistungsspitze (also einem relativen Maximum) einen geringen relativen Quantisierungsfehler haben; bei vier Empfangskanälen und gemeinsamer Skalierung von zwei aufeinanderfolgenden Entfernungstor werden also 8 komplexe Werte zusammen komprimiert,

- auch für eine Ausführung der Signalverarbeitung (insb. der DFTs) in Gleitkommaarithmetik kann eine Datenkomprimierung der abgespeicherten Werte nach der ersten DFT angewendet werden.

In Anhang sind noch Beispiele für die Komprimierung und Dekomprimierung anhand von Matlab-Skripten gegeben (Matlab ist eine mathematisch-technische Programmierhochsprache); in diesen Skripten sind Komprimierung und Dekomprimierung auch durch entsprechende Kommentare detailliert erläutert.

Die hier zuvor und im Anhang beschriebene Erfindung findet Anwendung in einem Prozessor für ein Radarsystem. Dazu wird z.B. die Komprimierung/Dekomrimierung entweder direkt in der Hardware umgesetzt (z.B. hart in Silizium gegossen) oder es wird ein Source Code mit dem erfindungsgemäßen Verfahren auf diesem Prozessor hinterlegt. Die Erfindung wird also als Verfahren und Vorrichtung für ein Radarsystem beansprucht.

## Patentansprüche

1. Radarsystem zur Umfelderfassung eines Kraftfahrzeugs mit

- Sendemitteln zur Abstrahlung von Sendesignalen mit einer oder mehreren Sendeantennen,
- Empfangsmitteln zum Empfang von an Objekte reflektierten Sendesignalen mit einer oder mehreren Empfangsantennen und
- Signalverarbeitungsmitteln zur Prozessierung der empfangenen Signale,

**wobei**

- die Frequenz der abgestrahlten Sendeleistung derart moduliert ist, dass sie eine Folge von K linearer Rampen gleicher Steigung beinhaltet,
- die Empfangssignale mehrerer Kombinationen von Sende- und Empfangsantennen durch Mischung mit einem Oszillatorsignal und Abtastung

  ∘ pro Frequenzrampe parallel und/oder
  ∘ über jeweils P aufeinanderfolgende Frequenzrampen, die eine Frequenzrampengruppe bilden, seriell, also K/P-mal,

akquiriert werden,
- in den digitalen Signalverarbeitungsmitteln Ergebnisse einer ersten Spektralanalyse jeweils über die Abtastwerte pro Frequenzrampe und pro jeweiligen Kombinationen von Sende- und Empfangsantenne berechnet werden,
- über die K Frequenzrampen die Ergebnisse dieser ersten Spektralanalyse für zumindest einen Teil ihrer Frequenzstützstellen, welche sogenannte Entfernungstore darstellen, abgespeichert werden,
- danach über die pro Entfernungstor und pro Kombination von Sende- und Empfangsantenne über die Frequenzrampen und/oder Frequenzrampengruppen abgespeicherten Ergebnisse der ersten Spektralanalyse eine zweite Spektralanalyse berechnet wird,
- und Ergebnisse der zweiten Spektralanalyse über die verschiedenen Kombinationen von Sende- und Empfangsantennen weiter prozessiert werden, insbesondere mittels einer digitale Strahlformung über eine dritte Spektralanalyse,

**dadurch gekennzeichnet, dass**

- die Ergebnisse der ersten Spektralanalyse zur Speicherplatzreduktion in komprimierter Form abgespeichert werden, wobei
- die Ergebnisse der ersten Spektralanalyse mehrerer Kombinationen von Sende- und Empfangsantenne pro Entfernungstor und Frequenzrampe und/oder Frequenzrampengruppe eine gleiche Skalierung erfahren und diese Skalierung mindestens einmal abgespeichert wird,
- die so skalierten Ergebnisse der ersten Spektralanalyse auf eine geringere Bitzahl als die in den Signalverarbeitungsmitteln, insbesondere bei den Spektralanalysen benutze Bitzahl quantisiert und mit dieser reduzierten Bitzahl abgespeichert werden, und
- diese komprimierten Ergebnisse der ersten Spektralanalyse vor der Berechnung der zweiten Spektralanalyse dekomprimiert werden.

2. Radarsystem nach Anspruch 1, wobei die Signalverarbeitungsmittel eingerichtet sind, die Ergebnisse, insbesondere die Ergebnisse der Spektralanalysen, in Festkommaarithmetik mit Zweierkomplementdarstellung zu berechnen.

3. Radarsystem nach Anspruch 2, wobei die gemeinsame Skalierung der Ergebnisse aus deren minimaler Anzahl von Bits mit jeweils gleichem Wert wie das oberste Bit bestimmt wird und zur Skalierung die so bestimmte Anzahl an Bits beginnend mit dem obersten Bit gestrichen wird.

4. Radarsystem nach einem der obigen Ansprüche, wobei die gemeinsame Skalierung der Ergebnisse sowie die skalierten und auf die geringere Bitzahl quantisierten Ergebnisse in einem gemeinsamen binären Wort codiert sind, dessen Bitanzahl vorzugsweise eine Zweierpotenz ist.

5. Radarsystem nach Anspruch 4, das für die in einem gemeinsamen binären Wort codierten skalierten Ergebnisse unterschiedliche Bitzahlen benutzt.

6. Radarsystem nach einem der obigen Ansprüche, das vor Quantisierung der skalierten Werte mindestens eine zufällige Zahl aufaddiert wird, welche die Quantisierungsfehler über die Frequenzrampen bzw. Frequenzrampengruppen und/oder die verschiedenen Kombinationen von Sende- und Empfangsantenne annähernd entkorreliert.

7. Radarsystem nach Anspruch 6, das eingerichtet ist, einen Stellenübertrag bei den Ergebnissen der ersten Spektralanalyse durch Addition einer zufälligen Zahl vor Quantisierung oder durch Rundung bei der Skalierung zu berücksichtigen.

8. Radarsystem nach einem der obigen Ansprüche, bei welchem die Ergebnisse mehrerer Kombinationen von Sende- und Empfangsantenne für mehrere, vorzugsweise zwei benachbarte Entfernungstore pro Frequenzrampe bzw. Frequenzrampengruppe gleiche Skalierung aufweisen und diese Skalierung mindestens einmal abgespeichert wird.

9. Radarsystem nach einem der obigen Ansprüche, bei welchem die digitalen Signalverarbeitungsmittel eine unterschiedliche Sensitivität von verschiedenen Kombinationen von Sende- und Empfangsantennen vor der Komprimierung ausgleichen.

10. Radarsystem nach einem der obigen Ansprüche, bei welchem die diskreten Fouriertransformationen (DFTs) über schnelle Fouriertransformationen (FFTs) bestimmt werden.

11. Verfahren für ein Radarsystem zur Umfelderfassung eines Kraftfahrzeugs mit den Schritten:

- Senden von Sendesignalen mit einer oder mehreren Sendeantennen,
- Empfangen von an Objekten reflektierten Sendesignalen mit einer oder mehreren Empfangsantennen und
- Prozessieren der empfangenen Signale,

**wobei**

- die Frequenz der abgestrahlten Sendeleistung derart moduliert wird, dass sie eine Folge von K linearer Rampen gleicher Steigung beinhaltet,
- die Empfangssignale mehrerer Kombinationen von Sende- und Empfangsantennen durch Mischung mit einem Oszillatorsignal und Abtastung

  ∘ pro Frequenzrampe parallel und/oder
  ∘ über jeweils P aufeinanderfolgende Frequenzrampen, die eine Frequenzrampengruppe bilden, seriell, also K/P-mal,

akquiriert werden,
- Ergebnisse einer ersten Spektralanalyse, insbesondere in Form einer diskreten Fouriertransformation (DFT), jeweils über die Abtastwerte pro Frequenzrampe und pro jeweiligen Kombinationen von Sende- und Empfangsantenne berechnet werden,
- über die K Frequenzrampen die Ergebnisse dieser ersten Spektralanalyse für zumindest einen Teil ihrer Frequenzstützstellen, welche sogenannte Entfernungstore darstellen, abgespeichert werden,
- danach über die pro Entfernungstor und pro Kombination von Sende- und Empfangsantenne über die Frequenzrampen und/oder Frequenzrampengruppen abgespeicherten Ergebnisse der ersten Spektralanalyse eine zweite Spektralanalyse, insbesondere in Form einer DFT berechnet wird, und
- die Ergebnisse der zweiten Spektralanalyse über die verschiedenen Kombinationen von Sende- und Empfangsantennen weiter prozessiert werden, insbesondere mittels einer digitalen Strahlformung über eine dritte DFT,

**dadurch gekennzeichnet, dass**

- die Ergebnisse der ersten Spektralanalyse zur Speicherplatzreduktion in komprimierter Form abgespeichert werden, wobei
- die Ergebnisse der ersten Spektralanalyse mehrerer Kombinationen von Sende- und Empfangsantenne pro Entfernungstor und Frequenzrampe und/oder Frequenzrampengruppe eine gleiche Skalierung erfahren und diese Skalierung mindestens einmal abgespeichert wird,
- die so skalierten Ergebnisse der ersten Spektralanalyse auf eine geringere Bitzahl als die beim Prozessieren, insbesondere bei den Spektralanalysen, benutze Bitzahl quantisiert und mit dieser reduzierten Bitzahl abgespeichert werden, und
- diese komprimierten Ergebnisse der ersten Spektralanalyse vor der Weiterverarbeitung, insbesondere vor der zweiten Spektralanalyse, wieder dekomprimiert werden.

12. Verfahren für ein Radarsystem nach Anspruch 11, wobei das Prozessieren, insbesondere die Spektralanalysen, in Festkommaarithmetik mit Zweierkomplementdarstellung durchgeführt wird.

13. Verfahren für ein Radarsystem nach Anspruch 12, wobei die gemeinsame Skalierung der Ergebnisse der ersten Spektralanalyse aus deren minimaler Anzahl von Bits mit jeweils gleichem Wert wie das oberste Bit bestimmt wird und zur Komprimierung die so bestimmte Anzahl an Bits beginnend mit dem obersten Bit gestrichen wird.

14. Verfahren für ein Radarsystem nach einem der obigen Ansprüche 11-13, wobei die gemeinsame Skalierung der Ergebnisse der ersten Spektralanalyse sowie die skalierten und die auf geringere Bitzahl quantisierten Ergebnisse der ersten Spektralanalyse in einem gemeinsamen binären Wort codiert werden, dessen Bitanzahl vorzugsweise eine Zweierpotenz ist.

15. Verfahren für ein Radarsystem nach Anspruch 14, wobei für die in einem gemeinsamen binären Wort codierten skalierten Ergebnisse der ersten Spektralanalyse unterschiedliche Bitzahlen benutzt werden, insbesondere um bei Vorgabe einer Zweierpotenz für dessen Bitanzahl diese optimal auszunutzen.

16. Verfahren für ein Radarsystem nach einem der obigen Ansprüche 11-15, wobei vor Quantisierung der skalierten Ergebnisse der ersten Spektralanalyse eine zufällige Zahl aufaddiert wird.

17. Verfahren für ein Radarsystem nach Anspruch 11-16, bei welchem durch Addition einer zufälligen Zahl vor Quantisierung oder durch Rundung die Skalierung angepasst wird.

18. Verfahren für ein Radarsystem nach einem der obigen Ansprüche 11-17, bei welchem die Ergebnisse mehrerer Kombinationen von Sende- und Empfangsantenne für mehrere, vorzugsweise zwei benachbarte Entfernungstore pro Frequenzrampe bzw. Frequenzrampengruppe gleiche Skalierung aufweisen und diese Skalierung mindestens einmal abgespeichert wird.

19. Verfahren für ein Radarsystem nach einem der obigen Ansprüche 11-18, bei welchem eine unterschiedliche Sensitivität von verschiedenen Kombinationen von Sende- und Empfangsantennen vor der Komprimierung ausgeglichen wird.

20. Verfahren für ein Radarsystem nach einem der obigen Ansprüche 11-19, bei welchem die diskreten Fouriertransformationen (DFTs) über schnelle Fouriertransformationen (FFTs) bestimmt werden.

## Claims

1. A radar system for detecting the surroundings of a motor vehicle, having

    - transmitting means for emitting transmission signals with one or more transmitting antennas,
    - receiving means for receiving transmission signals reflected off objects with one or more receiving antennas, and
    - signal processing means for processing the received signals,

    wherein

    - the frequency of the emitted transmitting power is modulated in such a way that it comprises a series of K linear ramps of the same gradient,
    - the received signals of multiple combinations of transmitting and receiving antennas are acquired by mixing with an oscillator signal and sampling

        ◦ in parallel for each frequency ramp, and/or
        ◦ serially over in each case P consecutive frequency ramps which form a group of frequency ramps, that is to say K/P-times,

    - results of a first spectral analysis are calculated in each case via the sampled values for each frequency ramp and for respective combinations of transmitting and receiving antennas in the digital signal processing means,
    - over the K frequency ramps, the results of said first spectral analysis are stored for at least a part of their frequency supporting points which represent so-called distance gates,
    - thereafter, a second spectral analysis is calculated by way of the results of the first spectral analysis stored for each distance gate and for each combination of transmitting and receiving antennas over the frequency ramps and/or groups of frequency ramps,
    - and results of the second spectral analysis are further processed over the various combinations of transmitting and receiving antennas, in particular by means of a digital beam formation via a third spectral analysis,

**characterized in that**

- the results of the first spectral analysis are stored in a compressed form in order to reduce the storage space, wherein
- the results of the first spectral analysis of multiple combinations of transmitting and receiving antennas experience the same scaling for each distance gate and frequency ramp and/or group of frequency ramps, and said scaling is stored at least once,
- the thus scaled results of the first spectral analysis are quantized to a lower bit number than the bit number used in the signal processing means, in particular during the spectral analyses, and are stored with said reduced bit number, and
- said compressed results of the first spectral analysis are decompressed prior to the calculation of the second spectral analysis.

2. The radar system according to Claim 1, wherein the signal processing means are set up to calculate the results, in particular the results of the spectral analyses, in fixed-point arithmetic with two's complement representation.

3. The radar system according to Claim 2, wherein the common scaling of the results is determined from the minimum number of bits thereof with, in each case, the same value as the uppermost bit and, in order to scale the thus determined number of bits, is deleted beginning with the uppermost bit.

4. The radar system according to any one of the above claims, wherein the common scaling of the results as well as the results which are scaled and quantized to the lower bit number are coded in a common binary word, the bit count of which is preferably a power of two.

5. The radar system according to Claim 4, which uses different bit numbers for the scaled results coded in a common binary word.

6. The radar system according to any one of the above claims, wherein at least one random number, which approximately decorrelates the quantization errors over the frequency ramps or groups of frequency ramps and/or the various combinations of transmitting and receiving antennas, is added prior to quantization of the scaled values.

7. The radar system according to Claim 6, which is set up to take account of a carry-out in the results of the first spectral analysis by adding a random number prior to quantization or by rounding during the scaling.

8. The radar system according to any one of the above claims, in which the results of multiple combinations of transmitting and receiving antennas for multiple, preferably two, neighboring distance gates have the same scaling for each frequency ramp or group of frequency ramps, and said scaling is stored at least once.

9. The radar system according to any one of the above claims, in which the digital signal processing means compensate a different sensitivity of various combinations of transmitting and receiving antennas prior to the compression.

10. The radar system according to any one of the above claims, in which the discrete Fourier transforms (DFTs) are determined by means of fast Fourier transforms (FFTs).

11. A method for a radar system for detecting the surroundings of a motor vehicle, having the steps of:

- transmitting transmission signals with one or more transmitting antennas,
- receiving transmission signals reflected off objects with one or more receiving antennas, and
- processing the received signals,

**wherein**

- the frequency of the emitted transmitting power is modulated in such a way that it comprises a series of K linear ramps of the same gradient,
- the received signals of multiple combinations of transmitting and receiving antennas are acquired by mixing with an oscillator signal and sampling

  ∘ in parallel for each frequency ramp, and/or

∘ serially over in each case P consecutive frequency ramps which form a group of frequency ramps, that is to say K/P-times,

- results of a first spectral analysis, in particular in the form of a discrete Fourier transform (DFT), are calculated in each case via the sampled values for each frequency ramp and for respective combinations of transmitting and receiving antennas,
- over the K frequency ramps, the results of said first spectral analysis are stored for at least a part of their frequency supporting points which represent so-called distance gates,
- thereafter, a second spectral analysis, in particular in the form of a DFT, is calculated by way of the results of the first spectral analysis stored for each distance gate and for each combination of transmitting and receiving antennas over the frequency ramps and/or groups of frequency ramps, and
- the results of the second spectral analysis are further processed over the various combinations of transmitting and receiving antennas, in particular by means of a digital beam formation by way of a third spectral analysis,

**characterized in that**

- the results of the first spectral analysis are stored in a compressed form in order to reduce the storage space, wherein
- the results of the first spectral analysis of multiple combinations of transmitting and receiving antennas experience the same scaling for each distance gate and frequency ramp and/or group of frequency ramps, and said scaling is stored at least once,
- the thus scaled results of the first spectral analysis are quantized to a lower bit number than the bit number used during the processing, in particular during the spectral analyses, and are stored with said reduced bit number, and
- said compressed results of the first spectral analysis are decompressed again prior to the further processing, in particular prior to the second spectral analysis.

12. The method for a radar system according to Claim 11, wherein the processing, in particular the spectral analyses, is performed in fixed-point arithmetic with two's complement representation.

13. The method for a radar system according to Claim 12, wherein the common scaling of the results of the first spectral analysis is determined from the minimum number of bits thereof with, in each case, the same value as the uppermost bit and, in order to compress the thus determined number of bits, is deleted beginning with the uppermost bit.

14. The method for a radar system according to any one of the above Claims 11-13, wherein the common scaling of the results of the first spectral analysis as well as the results of the first spectral analysis, which are scaled and quantized to the lower bit number, are coded in a common binary word, the bit count of which is preferably a power of two.

15. The method for a radar system according to Claim 14, wherein different bit numbers are used for the scaled results of the first spectral analysis coded in a common binary word, in particular in order to make optimum use thereof when specifying a power of two for the bit number thereof.

16. The method for a radar system according to any one of the above Claims 11-15, wherein a random number is added prior to quantization of the scaled results of the first spectral analysis.

17. The method for a radar system according to Claims 11-16, in which the scaling is adjusted by adding a random number prior to quantization or by rounding.

18. The method for a radar system according to any one of the above Claims 11-17, in which the results of multiple combinations of transmitting and receiving antennas for multiple, preferably two, neighboring distance gates have the same scaling for each frequency ramp or group of frequency ramps, and said scaling is stored at least once.

19. The method for a radar system according to any one of the above Claims 11-18, in which a different sensitivity of various combinations of transmitting and receiving antennas is compensated prior to the compression.

20. The method for a radar system according to any one of the above Claims 11-19, in which the discrete Fourier transforms (DFTs) are determined by means of fast Fourier transforms (FFTs).

**Revendications**

1. Système radar pour la détection de l'environnement d'un véhicule, avec

   - des moyens d'émission pour la diffusion de signaux d'émission avec une ou plusieurs antennes d'émission,
   - des moyens de réception pour la réception de signaux d'émission réfléchis sur des objets avec une ou plusieurs antennes de réception, et
   - des moyens de traitement du signal pour le traitement des signaux reçus,
   - la fréquence de la puissance d'émission diffusée étant modulée de telle sorte qu'elle contient une succession de K rampes linéaires de même pente,
   - les signaux de réception de plusieurs combinaisons d'antennes d'émission et de réception étant acquis par mélange avec un signal d'oscillateur et échantillonnage

     ◦ de façon parallèle, par rampe de fréquence et/ou
     ◦ de façon sérielle, par respectivement P rampes de fréquences se succédant, lesquelles forment un groupe de rampes de fréquences, donc K/P fois,

   - des résultats d'une première analyse spectrale étant calculés respectivement par la valeur d'échantillonnage par rampe de fréquence et par combinaisons respectives d'antennes d'émission et de réception, dans les moyens de traitement du signal numériques,
   - les résultats de cette première analyse spectrale étant enregistrés par les K rampes de fréquences, pour au moins une partie de leur nœuds de fréquence, lesquels représentent des « fenêtres de distance »,
   - une deuxième analyse spectrale étant calculée ensuite, à l'aide des résultats de la première analyse spectrale enregistrés par fenêtre de distance et par combinaison d'antennes d'émission et de réception par les rampes de fréquences et/ou les groupes de rampes de fréquences,
   - et les résultats de la deuxième analyse spectrale par les différentes combinaisons d'antennes d'émission et de réception étant traités à leur tour, en particulier au moyen d'une formation de faisceau numérique par une troisième analyse spectrale,

   **caractérisé en ce que**

   - les résultats de la première analyse spectrale sont enregistrés sous forme comprimée en vue d'une réduction de place mémoire,
   - les résultats de la première analyse spectrale de plusieurs combinaisons d'antennes d'émission et de réception par fenêtre de distance et rampe de fréquence et/ou groupe de rampes de fréquences subissant une même mise à l'échelle et cette mise à l'échelle étant enregistrée au moins une fois,
   - les résultats de la première analyse spectrale ainsi mis à l'échelle étant quantifiés avec un nombre de bits inférieur au nombre de bits utilisé dans les moyens de traitement du signal, en particulier lors des analyses spectrales, et étant enregistrés avec ce nombre de bits réduit, et
   - ces résultats de la première analyse spectrale comprimés étant décomprimés avant le calcul de la deuxième analyse spectrale.

2. Système radar selon la revendication 1, les moyens de traitement du signal étant agencés de telle sorte que les résultats, en particulier les résultats des analyses spectrales, sont calculés en arithmétique en virgule fixe avec représentation en complément à deux.

3. Système radar selon la revendication 2, la mise à l'échelle commune des résultats étant déterminée à partir de leur nombre minimal de bits avec respectivement la même valeur que le bit de poids fort, et le nombre de bits déterminé ainsi étant supprimé en vue de la mise à l'échelle, en commençant par le bit de poids fort.

4. Système radar selon l'une des revendications précédentes, la mise à l'échelle commune des résultats ainsi que les résultats mis à l'échelle et quantifiés au nombre de bits le plus faible étant codés en un mot binaire commun, dont le nombre de bits est de préférence une puissance de deux.

5. Système radar selon la revendication 4, utilisant des nombres de bits différents pour les résultats mis à l'échelle codés en un mot binaire commun.

6. Système radar selon l'une des revendications précédentes, au moins un nombre aléatoire étant ajouté avant la quantification des valeurs mises à l'échelle, lequel nombre décorrèle par approximation les erreurs de quantification par les rampes de fréquences ou les groupes de rampes de fréquences et/ou les différentes combinaisons d'antennes d'émission et de réception.

7. Système radar selon la revendication 6, lequel est agencé afin de prendre en compte un report de position dans les résultats de la première analyse spectrale par l'addition d'un nombre aléatoire avant la quantification ou par arrondissement lors de la mise à l'échelle.

8. Système radar selon l'une des revendications précédentes, **caractérisé en ce que** les résultats de plusieurs combinaisons d'antennes d'émission et de réception présentent la même mise à l'échelle pour plusieurs fenêtres de distance, de préférence deux fenêtres de distance voisines, par rampe de fréquence ou par groupe de rampes de fréquences, et **en ce que** cette mise à l'échelle est enregistrée au moins une fois.

9. Système radar selon l'une des revendications précédentes, **caractérisé en ce que** les moyens de traitement du signal numériques compensent une sensibilité différente de différentes combinaisons d'antennes d'émission et de réception avant la compression.

10. Système radar selon l'une des revendications précédentes, **caractérisé en ce que** les transformations de Fourier discrètes (TFD) sont déterminées par des transformations de Fourier rapides (TFR).

11. Procédé pour un système radar pour la détection de l'environnement d'un véhicule à moteur, avec les étapes :

- émission de signaux d'émission avec une ou plusieurs antennes d'émission,
- réception de signaux d'émission réfléchis sur des objets avec une ou plusieurs antennes de réception, et
- traitement des signaux reçus,
- la fréquence de la puissance d'émission diffusée étant modulée de telle sorte qu'elle contient une succession de K rampes linéaires de même pente,
- les signaux de réception de plusieurs combinaisons d'antennes d'émission et de réception étant acquis par mélange avec un signal d'oscillateur et échantillonnage

◦ de façon parallèle, par rampe de fréquence et/ou
◦ de façon sérielle, par respectivement P rampes de fréquences se succédant, lesquelles forment un groupe de rampes de fréquences, donc K/P fois,

- des résultats d'une première analyse spectrale, en particulier sous la forme d'une transformation de Fourier discrète (TFD), étant calculés respectivement par la valeur d'échantillonnage par rampe de fréquence et par combinaisons respectives d'antennes d'émission et de réception,
- les résultats de cette première analyse spectrale étant enregistrés par les K rampes de fréquences, pour au moins une partie de leur nœuds de fréquence, lesquels représentent des « fenêtres de distance »,
- une deuxième analyse spectrale, en particulier sous la forme d'une TFD, étant calculée à l'aide des résultats enregistrés par fenêtre de distance et par combinaison d'antennes d'émission et de réception par les rampes de fréquences et/ou les groupes de rampes de fréquences, et
- les résultats de la deuxième analyse spectrale par les différentes combinaisons d'antennes d'émission et de réception étant traités à leur tour, en particulier au moyen d'une formation de faisceau numérique par une troisième TFD,

**caractérisé en ce que**

- les résultats de la première analyse spectrale sont enregistrés sous forme comprimée en vue d'une réduction de place mémoire,
- les résultats de la première analyse spectrale de plusieurs combinaisons d'antennes d'émission et de réception par fenêtre de distance et rampe de fréquence et/ou groupe de rampes de fréquences subissant une même mise à l'échelle et cette mise à l'échelle étant enregistrée au moins une fois,
- les résultats de la première analyse spectrale ainsi mis à l'échelle étant quantifiés avec un nombre de bits inférieur au nombre de bits utilisé lors du traitement, en particulier lors des analyses spectrales, et étant enregistrés avec ce nombre de bits réduit, et
- ces résultats de la première analyse spectrale comprimés étant de nouveau décomprimés avant la poursuite du traitement, en particulier avant le calcul de la deuxième analyse spectrale.

**12.** Procédé pour un système radar selon la revendication 11, le traitement, en particulier les analyses spectrales, étant effectué en arithmétique en virgule fixe avec représentation en complément à deux.

**13.** Procédé pour un système radar selon la revendication 12, la mise à l'échelle commune des résultats de la première analyse spectrale étant déterminée à partir de leur nombre minimum de bits ayant respectivement la même valeur que le bit de poids fort, et le nombre de bits déterminé ainsi étant supprimé en vue de la compression, en commençant par le bit de poids fort.

**14.** Procédé pour un système radar selon l'une des revendications précédentes 11-13, la mise à l'échelle commune des résultats de la première analyse spectrale ainsi que les résultats de la première analyse spectrale mis à l'échelle et quantifiés avec un nombre de bits plus faible étant codés en un mot binaire commun, dont le nombre de bits est de préférence une puissance de deux.

**15.** Procédé pour un système radar selon la revendication 14, des nombres de bits différents étant utilisés pour les résultats mis à l'échelle codés en un mot binaire commun, en particulier, lors de la spécification d'une puissance de deux, pour exploiter ceux-ci de façon optimale pour son nombre de bits.

**16.** Procédé pour un système radar selon l'une des revendications précédentes 11-15, un nombre aléatoire étant ajouté avant quantification des résultats mis à l'échelle de la première analyse spectrale.

**17.** Procédé pour un système radar selon les revendications 11-16, **caractérisé en ce que** la mise à l'échelle est ajustée par l'addition d'un nombre aléatoire avant quantification ou par arrondissement.

**18.** Procédé pour un système radar selon l'une des revendications précédentes 11-17, **caractérisé en ce que** les résultats de plusieurs combinaisons d'antennes d'émission et de réception présentent la même mise à l'échelle pour plusieurs fenêtres de distance, de préférence deux fenêtres de distance voisines, par rampe de fréquence ou par groupe de rampes de fréquences, et **en ce que** cette mise à l'échelle est enregistrée au moins une fois.

**19.** Procédé pour un système radar selon l'une des revendications précédentes 11-18, **caractérisé en ce qu'**une sensibilité différente de différentes combinaisons d'antennes d'émission et de réception est compensée avant la compression avant la compression.

**20.** Procédé pour un système radar selon l'une des revendications précédentes 11-19, **caractérisé en ce que** les transformations de Fourier discrètes (TFD) sont déterminées par des transformations de Fourier rapides (TFR).

**Fig. 1**

**Fig. 2**

Fig.3

Fig. 4

Entfernungstore

r $\quad$ j $\qquad$ **Leistungsspitze von**
**Obj. 1** bzw. Obj. 2

199m 199

9m $\quad$ 9

5m $\quad$ 5
4m $\quad$ 4
3m $\quad$ 3
2m $\quad$ 2
1m $\quad$ 1
0m $\quad$ 0

0 1 2 3 $\quad$ 512 $\qquad$ 1023 $\quad$ Dopplertore I

$\rightarrow$ $v_{rel}$ in km/h

| -2236 | -1677 | -1118 |
| -1118 | -559 | 0 |
| 0 | 559 | 1118 |
| 1118 | 1677 | 2236 |

**Fig. 5**

Objekt ●

Zusammenhang zwischen Azimutwinkel α
und Phasendifferenzen:
α = arcsin(b/d)
mit b = (φ(0)-φ(1))*λ/(2π) und λ=c/79GHz

für Phasendifferenzen gilt:
φ(0)-φ(m) = 2π·m·b/λ,
wobei φ(m) die Phase der
Empfangswelle bei
RXm, m = 0,1,2,3, ist

3b

2b

α $\quad$ b

α

d $\qquad$ d $\qquad$ d

TX $\qquad$ RX0 $\quad$ RX1 $\quad$ RX2 $\quad$ RX3

**Fig. 6**

**3-dimensonale DFT**

(vier Werte aus vier RX-Kanälen um vier Nullen ergänzt)

Leistungsspitzen von **Objekt 1** u. *Objekt 2*

i: Index von Abtastwert in Rampe

k: Rampenummer

m: RXm

Entfernungs-tore

r / j

v_rel in km/h

Dopplertore l

Winkeltore n

α für d = λ/2

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010115418 A2
- WO 2014029260 A